# EUROPÄISCHE PATENTSCHRIFT

(11) **EP 1 659 846 B1**
(45) Veröffentlichungstag und Bekanntmachung des Hinweises auf die Patenterteilung: **11.04.2007**
(21) Anmeldenummer: 05021057.4
(22) Anmeldetag: 27.09.2005
(51) Int. Cl.: H05K 9/00

(54) **Befestigungssystem eines Einlegeteils mittels eines Dichtschaumes**
Sealing of a cover by means of a foam
Fixation étanche d'un couvercle au moyen d'une mousse

(30) Priorität: 19.11.2004 DE 202004017988 U
(43) Veröffentlichungstag der Anmeldung: 24.05.2006
(73) Patentinhaber: Knürr AG, 94424 Arnstorf (DE)
(72) Erfinder: Hausleitner, Anton, 94424 Arnstorf (DE); Wagner, Josef, 94439 Rossbach (DE); Wiedl, Manfred, 84378 Dietersburg (DE); Bumeder, Gerhard, 84164 Moosthenning (DE); Knab, Josef, 94439 Rossbach (DE)
(74) Vertreter: Heim, Hans-Karl

(56) Entgegenhaltungen:
- WO-A-01/54467
- WO-A-03/021774
- WO-A-03/049521
- US-A1- 2001 009 194
- US-B1- 6 547 252

## Beschreibung

Die Erfindung betrifft ein Befestigungssystem gemäß dem Oberbegriff des Anspruchs 1.

Es handelt sich hierbei um ein Befestigungssystem zur Befestigung eines Einlegeteils, insbesondere eines Lochbleches, an einem flächigen Teil oder Rahmenteil z.B. für Schränke und Gehäuse der Daten-/Netzwerktechnik, der Servertechnik, oder Medizintechnik. Lochbleche werden oft in konventionellen Serverschränken genutzt, um einen möglichst hohen Luftstrom zur Kühlung des Servers zu ermöglichen.

Diese Lochbleche werden meist mit Schweißpunkten an einem Untergrund oder einem Rahmen befestigt. Nachteilig an dieser Befestigung ist, dass durch die hohen Temperaturen beim Schweißen ein Verziehen der Bleche auftreten kann, so dass sie nicht mehr exakt die zuvor geplante Form besitzen. Somit passen sie nicht mehr optimal in den vorbereiteten Rahmen oder auf die vorbereitete Fläche.

Eine andere Art der Befestigung des Lochbleches an einem Gegenstand ist die Verwendung von Klemmwinkeln. Diese werden auch als L-Winkel, Z-Winkel, Kunststoffklammern oder Blechlaschen realisiert.
Diese Art der Befestigung drückt das Lochblech auf die Unterlage bzw. den Rahmen. Diese Befestigung hat den Nachteil, dass zusätzliche Komponenten genutzt werden müssen. Es besteht Verbesserungsbedarf in der Haltekraft und Stabilität dieser Befestigung, da diese nur im Kontaktbereich der Klemmwinkel mit dem Lochblech stattfindet und so nur sehr punktuell wirken kann. Außerdem kommt es bei dieser Art von Befestigung dazu, dass das Lochblech zwischen den Befestigungspunkten "baucht". Neben der optischen Beeinträchtigung durch ein durchhängendes Lochblech stellt dies auch eine erhöhte Beanspruchung des Materials dar.

Aus der US 2001/009194 A1 ist ein Verfahren zum Versiegeln und Abschirmen von elektronischen Gehäusen bekannt. Dieses kann auch zur Befestigung beispielsweise eines Maschendrahtes dienen. Hierzu wird der Maschendraht auf das Gehäuse gelegt, so dass sein äußeres Ende mit einer Kante des Gehäuses einen Kanal bildet. In diesem Kanal wird dann ein Schaum eingebracht, der den entstandenen Kanal ausfüllt und somit den Maschendraht seitlich ahärent an dem Gehäuse befestigt.

Der Erfindung liegt die **Aufgabe** zugrunde, ein einfaches und effektives Befestigungssystem zur Befestigung eines Einlegeteils, insbesondere in Form eines Lochbleches, an einem Gegenstand oder Untergrund davon anzugeben.

Die Aufgabe wird erfindungsgemäß durch ein Befestigungssystem mit den Merkmalen des Anspruchs 1 gelöst. Demnach ist vorgesehen, dass das Einlegeteil auf dem flächigen Teil oder Rahmenteil angeordnet ist und dass das Einlegeteil mittels eines Dichtschaums, der Öffnungen des Einlegeteils mindestens teilweise durchdringt oder umschließt, an gewünschten Bereichen gegen das flächige Teil oder das Rahmenteil fixiert ist. Das Befestigungssystem ist so ausgelegt, dass das Lochblech an den Fixierbereichen in verfestigtem Dichtschaum eingebettet bzw. ummantelt ist. Dadurch, dass das Lochblech nicht nur auf dem Dichtschaum zu liegen kommt, sondern von diesem eingebettet ist, wird die Festigkeit der Befestigungsanordnung bzw. des Systems weiter erhöht. Auch kann durch diese Einbettung das Lochblech an den eingebetteten Stellen vor äußeren Einflüssen geschützt werden.

Weitere vorteilhafte Ausführungsformen sind in den abhängigen Ansprüchen angegeben.

Der Begriff "Einlegeteil" kann hierbei insbesondere ein Lochblech, aber z.B. auch ein Blechzuschnitt mit gestanzten Laschen im Randbereich oder ein Gitter sein, wobei die Berandung mit entsprechenden Öffnungen oder Laschen ausgestattet ist. Nachfolgend wird daher nur beispielhaft von Lochblech gesprochen.

Ein Grundgedanke der Erfindung ist es, die Befestigung eines Lochbleches als Einlegeteil an einem Rahmen möglichst einfach auszuführen. Dies wird bei dem erfindungsgemäßen Befestigungssystem durch die Verwendung von Dichtschaum realisiert. Da das Lochblech komplett auf dem Rahmen aufliegt und hierbei durch den Dichtschaum fixiert wird, können die Nachteile des Standes der Technik überwunden werden. Es sind also keine zusätzlichen Klemmwinkel oder ein Verschweißen des Lochbleches mehr notwendig. Neben einer Kostenreduzierung ist die Befestigung mit dem Befestigungssystem deutlich schneller und einfacher anzubringen.

Grundsätzlich ist es möglich, das Lochblech nur an wenigen Stellen unter Zuhilfenahme des Dichtschaums an dem Rahmenteil zu befestigen. Es hat sich aber als vorteilhaft herausgestellt, wenn das Lochblech an seinem Umfang zumindest teilweise durch Dichtschaum mit dem flächigen Teil oder dem Rahmenteil verbunden ist. Hierdurch kann eine erhöhte Festigkeit der Verbindung erreicht werden. Auch kann mit einer solchen Befestigungsanordnung ein "Bauchen" des Lochbleches weitgehend vermieden werden, da etwaige Unebenheiten des Rahmenteils durch die Dichtmasse ausgeglichen werden können und so das Lochblech in seinem Umfang größtenteils aufliegend gelagert ist.

Der Dichtschaum, der in diesem Befestigungssystem benutzt wird, ist bevorzugterweise ein Mehrkomponenten-, insbesondere Zweikomponenten-Dichtschaum. Hierbei bietet sich beispielsweise Polyurethan an. Durch die Verwendung eines Mehrkomponenten-Dichtschaums, der erst nach dem Aufbringen ausschäumt, besteht die Möglichkeit, bei der Herstellung eines solchen Befestigungssystems den noch nicht ausgeschäumten Dichtschaum besser in die Löcher des Lochbleches laufen zu lassen und so eine noch bessere Verbindung mit dem flächigen Untergrund herzustellen. Gegebenenfalls kann auch klebstoffartiger Schaum oder Material verwendet werden.

Ein besonders bevorzugtes Befestigungssystem ist ferner dadurch gekennzeichnet, dass das Rahmenteil eine Stufe zur Aufnahme des Lochbleches aufweist und dass der äußere Teil des Rahmens und das Lochblech eine im Wesentlichen ebene Fläche bilden. Durch diese Stufe wird eine Führung zum Einlegen des Lochbleches in das Rahmenteil geschaffen. Somit ist das Lochblech in dem Rahmen provisorisch fixiert, um dann durch den Dichtschaum endgültig befestigt zu werden. Außerdem wird durch die Stufe erreicht, dass das Lochblech im Vergleich zum äußeren Teil des Rahmens abgesenkt ist und so zusammen mit dem äußeren Teil des Rahmens eine ebene Fläche bildet. Dies sieht nicht nur optisch ansprechender aus, sondern bietet auch den Vorteil, dass das Befestigungssystem mit dem Lochblech in dem Rahmen geschützter befestigt ist.

Grundsätzlich kann ein solches Rahmenteil überall befestigt werden. Besonders vorteilhaft können solche Rahmenteile mit dem auf ihnen angebrachten Befestigungssystem aber als Teil einer Tür oder Teil eines Seitenbereiches eines EDV-Gehäuses oder Schrankes ausgeführt sein. Durch die Verwendung des Befestigungssystems kann ein Lochblech als Tür oder als Seitenwand verwendet werden. So wird eine bessere Luftzirkulation innerhalb des Gehäuses realisiert. Durch diesen verbesserten Luftstrom ist auch der Wärmeaustausch der Komponenten innerhalb des Gehäuses mit der Umgebungsluft verbessert.

Im Gegensatz zu herkömmlichen Befestigungssystemen kann mit der erfindungsgemäßen Befestigungsanordnung auch ein Lochblech verwendet werden, welches einen großen Lochanteil aufweist. Durch die Befestigung eines solchen Lochbleches am Rahmen mit der erfindungsgemäßen Befestigungsanordnung ist die Größe des Lochanteils unwesentlich geworden, da der Dichtschaum den gesamten Randbereich des Lochbleches umschließt und somit eine feste Befestigung des Lochbleches an der Rahmenstruktur oder dem flächigen Untergrund bewirken kann.

Ein besonders bevorzugtes Befestigungssystem kann dadurch erreicht werden, dass der Dichtschaum EMV-Eigenschaften aufweist, und dass durch den Dichtschaum der flächige Teil oder das Rahmenteil und das Lochblech leitend verbunden sind. Durch die Verwendung eines EMV-Dichtschaums wird sicher gestellt, dass keine elektromagnetische Strahlung zwischen dem Lochblech und dem Rahmen hindurchdringen kann. Somit werden auch die erhöhten Anforderungen an beispielsweise medizinische Geräte erfüllt, die sonst durch EM-Abstrahlung beeinflusst werden können.
Für eine optimale Erdung wird zweckmäßiger Weise ein separates Kabel vorgesehen.

In einem besonders bevorzugten Ausführungsbeispiel sind in den Bereichen, an denen das Lochblech von Dichtungsschaum eingebettet ist, Mittel zur Kanalisierung des Luftstroms befestigt. Somit können diese Mittel ohne zusätzliche Befestigungseinrichtungen mit dem Befestigungssystem angebracht werden. Diese Mittel zur Kanalisierung des Luftstromes führen dazu, einen Luftstrom gezielt an bestimmte Bereiche der sich in dem Gehäuse befindenden Bauteile zu leiten. Dies ist notwendig, da einige Bauteile größere Abwärme produzieren, als andere.

Ferner ist es besonders vorteilhaft, wenn die Mittel zur Kanalisierung des Luftstroms luft- und/oder EMV-dicht befestigt sind. Eine luftdichte Befestigung der Mittel erhöht ihre Kanalisierungswirkung und verbessert somit die Leitung des Luftstroms. Auch können Geräte mit einem solchen erfindungsgemäßen Befestigungssystem einfacher in EMV-kritischen Umgebungen eingesetzt werden.

Die Erfindung wird nachfolgend anhand von Ausführungsbeispielen und schematischen Zeichnungen näher erläutert. In diesen Zeichnungen zeigen:
- Fig. 1: eine Frontansicht auf einen Rahmen, an dem teilweise ein Lochblech mit dem erfindungsgemäßen Befestigungssystem befestigt ist;
- Fig. 2: eine seitlich geschnittene Ansicht eines ersten Ausführungsbeispiels des Befestigungssystems;
- Fig. 3: eine seitlich geschnittene Ansicht eines zweiten Ausführungsbeispiels des Befestigungssystems;
- Fig. 4: eine seitlich geschnittene Ansicht eines Befestigungssystems mit einer Stufe im Rahmen; und
- Fig. 5: eine seitlich geschnittene Ansicht eines Befestigungssystems mit einer Doppelstufe im Rahmen.

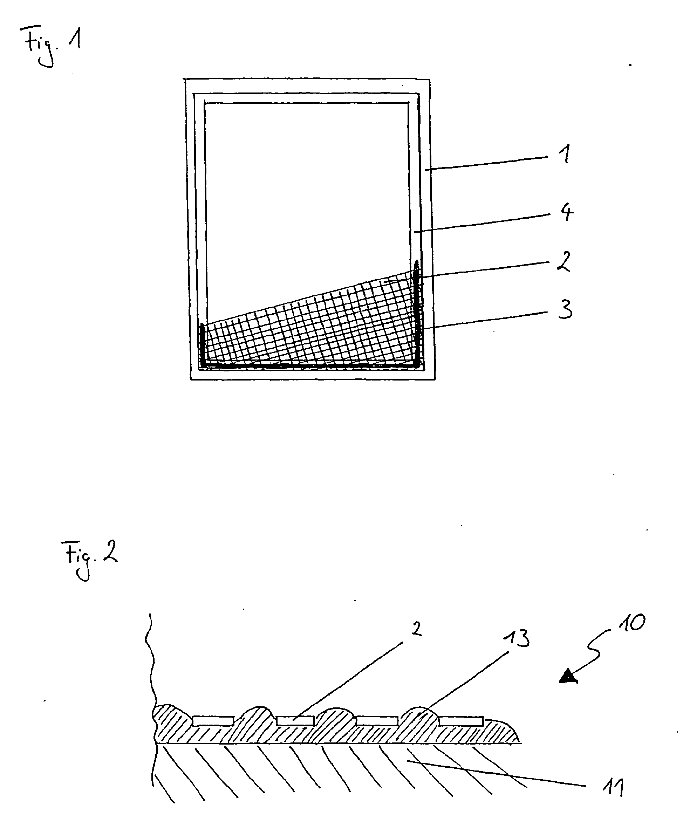

Fig. 1 zeigt eine Frontansicht auf einen Rahmen 1. An diesen Rahmen 1 ist teilweise ein Einlegeteil als Lochblech 2 mit dem Befestigungssystem befestigt. Zum besseren Einpassen des Lochbleches 2 in den Rahmen 1 weist dieser eine Stufe 4 auf. Weiter ist auf dieser Abbildung eine Dichtschaumraupe 3 gezeigt, die das Lochblech 2 an dem Rahmen 1 befestigt. Auch kann der gesamte Innenraum des Rahmens 1 mit einem Lochblech 2 belegt werden und dieses mit dem Befestigungssystem angebracht werden.

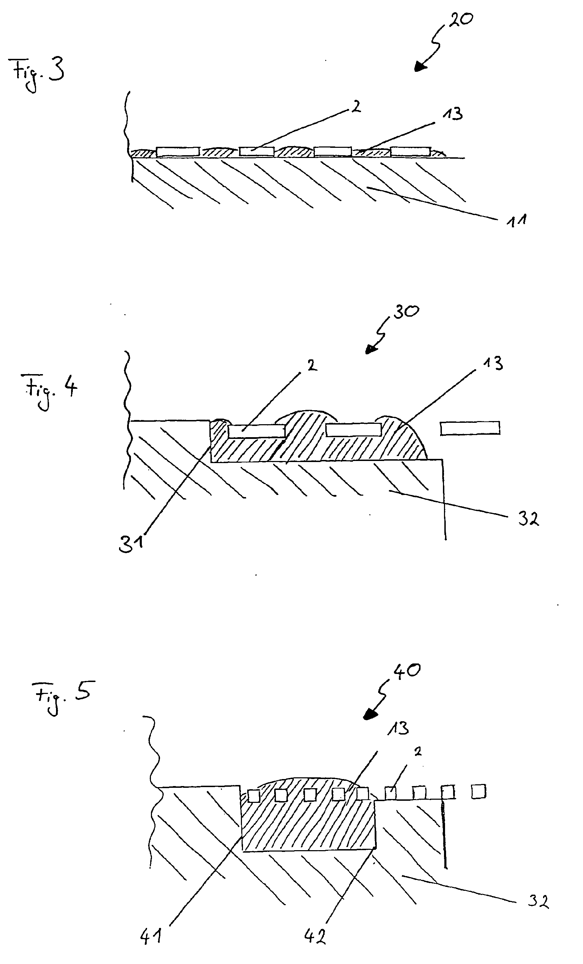

Fig. 2 zeigt eine seitlich geschnittene Ansicht eines ersten Ausführungsbeispiels des Befestigungssystems 10. In diesem Beispiel befindet sich zwischen dem Lochblech 2 und dem Untergrund 11 Dichtschaum 13. Der Dichtschaum 13 steht über das Lochblech 2 hinaus. Ein solches Befestigungssystem 10 kann erhalten werden, indem zuerst der Dichtschaum 13 auf den Untergrund 11 aufgetragen wird und dann das Lochblech 2 auf den aushärtenden Dichtschaum 13 aufgebracht wird.

Die seitlich geschnittene Ansicht in Fig. 3 zeigt ein zweites Ausführungsbeispiel des Befestigungssystems 20. Bei diesem Befestigungssystem 20 befindet sich kaum oder kein Dichtschaum 13 zwischen dem Lochblech 2 und dem Untergrund 11. Der Dichtschaum 13 befindet sich hauptsächlich zwischen den Stegen des Lochbleches 2, sozusagen in den Löchern. Eine solche Ausführungsform kann erreicht werden, wenn ein anfangs sehr flüssiger Dichtschaum 13 auf ein Lochblech 2 aufgebracht wird, welches sich bereits auf dem Untergrund 11 befindet.

Fig. 4 zeigt eine seitlich geschnittene Ansicht eines Befestigungssystems 30 mit einer Stufe 31 im Rahmen 32. Die Stufe 31 dient unter anderem zur besseren Platzierung des Lochbleches 2. Bei diesem Befestigungssystem 30 ist gezeigt, dass der Dichtschaum 13 auch über die Oberseite des Lochbleches 2 hinausreicht und so einen überstehenden Teil ausbildet. Durch die Stufe 31 im Rahmen 32 wird außerdem erreicht, dass durch den äußeren Rand des Rahmens 32 und das Lochblech 2 eine im Wesentlichen ebene Fläche gebildet ist.

Ein ähnliches Befestigungssystem 40 ist in Fig. 5 dargestellt. Dieses Befestigungssystem 40 besitzt zwei Stufen 41, 42 bzw. eine Nut. Diese beiden Stufen 41, 42 bilden einen Hohlraum in den der Dichtschaum 13 fließen kann. Durch die zweite Stufe 42 im Rahmen 32 kann das Lochblech auf den Rahmen 32 aufgelegt werden. In dieser Ausführungsform umschließt bzw. ummantelt der Dichtschaum 13 Teile des Lochbleches 2 vollkommen. An diesem überstehenden Teil des Dichtschaums 13 können Mittel zur Luftstromkanalisierung angebracht werden.

Das erfindungsgemäße Befestigungssystem bietet somit ein einfaches und effektives Konzept, um Lochbleche an flächigen Teilen oder Rahmenteilen zu befestigen.

## Patentansprüche

1. Befestigungssystem zur Befestigung eines Einlegeteils (2), insbesondere eines Lochbleches, an einem flächigen Teil oder Rahmenteil (1), wobei
das Einlegeteil (2) auf dem flächigen Teil oder Rahmenteil (1) angeordnet ist,
**dadurch gekennzeichnet,**
**dass** das Einlegeteil (2) mittels eines Dichtschaums (13), der Öffnungen des Einlegeteiles (2) mindestens teilweise durchdringt oder umschließt, an gewünschten Bereichen gegen das flächige Teil oder das Rahmenteil (1) fixiert ist,
**dass** der Dichtschaum (13) auf dem Einlegeteil (2) aufgebracht ist, und
**dass** das Einlegeteil (2) an den Fixierbereichen in verfestigtem Dichtschaum (13) eingebettet ist.

2. Befestigungssystem nach Anspruch 1,
**dadurch gekenzeichnet,**
**dass** das Einlegeteil (2) an seinem Umfang zumindest teilweise durch Dichtschaum (13) mit dem flächigen Teil oder dem Rahmenteil (1) verbunden ist.

3. Befestigungssystem nach Anspruch 1 oder 2,
**dadurch gekennzeichnet,**
**dass** der Dichtschaum (13) ein Mehrkomponenten-, insbesondere Zweikomponenten-Dichtschaum, ist.

4. Befestigungssystem nach einem der Ansprüche 1 bis 3,
**dadurch gekennzeichnet,**
**dass** das Rahmenteil (1) mindestens eine Stufe (31) zur Aufnahme des Einlegeteiles (2) aufweist, und
**dass** der äußere Teil des Rahmens (1) und das Einlegeteil (2) eine im Wesentlichen ebene Fläche bilden.

5. Befestigungssystem nach einem der Ansprüche 1 bis 4,
**dadurch gekennzeichnet,**
**dass** das Rahmenteil (1) Teil einer Tür oder Teil eines Seitenbereiches eines EDV-Gehäuses oder Schrankes, insbesondere der Daten-, Netzwerktechnik oder Servertechnik oder Medizintechnik, ist.

6. Befestigungssystem nach einem der Ansprüche 1 bis 5,
**dadurch gekennzeichnet,**
**dass** das Einlegeteil ein Lochblech (2) mit großem Lochanteil ist.

7. Befestigungssystem nach einem der Ansprüche 1 bis 6,
**dadurch gekennzeichnet,**
**dass** der Dichtschaum (13) EMV-Eigenschaften aufweist, und
**dass** durch den Dichtschaum (13) der flächige Teil oder das Rahmenteil (1) und das Einlegeteil leitend verbunden sind.

8. Befestigungssystem nach einem der Ansprüche 1 bis 7,
**dadurch gekennzeichnet,**
**dass** in den Bereichen, an denen das Einlegeteil (2) vom Dichtungsschaum (13) eingebettet ist, Mittel zur Kanalisierung eines Luftstroms befestigt sind.

9. Befestigungssystem nach Anspruch 8,
**dadurch gekennzeichnet,**
**dass** die Mittel zur Kanalisierung des Luftstroms luft- und/oder EMV-dicht befestigt sind.

## Claims

1. Fixing system for fixing an insert part (2), particularly a perforated plate, to a flat part or frame part (1),
in which the insert part (2) is placed on the flat part or frame part (1),
**characterized in**
**that** the insert part (2) is fixed in desired areas against the flat part or frame part (1) by means of a sealing foam (13), which at least partly penetrates or encloses openings of insert part (2),
**that** the sealing foam (13) is applied to the insert part (2) and
**that** the insert part (2) at the fixing areas is embedded in the hardened sealing foam (13).

2. Fixing system according to claim 1,
**characterized in that**
at its circumference, insert part (2) is at least partly connected to the flat part or frame part (1) by sealing foam (13).

3. Fixing system according to claim 1 or 2,
**characterized in that**
said sealing foam (13) is a multicomponent, particularly two-component sealing foam.

4. Fixing system according to one of the claims 1 to 3,
**characterized in**
**that** frame part (1) has at least one step (31) for receiving insert part (2) and that the outer part of frame (1) and insert part (2) form a substantially planar surface.

5. Fixing system according to one of the claims 1 to 4,
**characterized in that**
the frame part (1) is part of a door or part of a side area of an EDP enclosure or cabinet, particularly in connection with data, network, server or medical technology.

6. Fixing system according to one of the claims 1 to 5,
**characterized in that**
the insert part is a perforated plate (2) with a large number of holes.

7. Fixing system according to one of the claims 1 to 6,
**characterized in**
**that** the sealing foam (13) has EMC characteristics and
**that** the flat part or frame part (1) and the insert part are conductively connected by the sealing foam (13).

8. Fixing system according to one of the claims 1 to 7,
**characterized in that**
in the areas where the insert part (2) is embedded by the sealing foam (13) air flow channelling means are provided.

9. Fixing system according to claim 8,
**characterized in that**
the air flow channelling means are fixed in airtight and/or EMC-tight manner.

## Revendications

1. Système de fixation d'une pièce d'insertion (2), en particulier d'une tôle perforée, sur une pièce plate ou une pièce de cadre (1), en installant la pièce d'insertion (2) sur la pièce plate ou la pièce de cadre (1),
**caractérisé en ce que**
la pièce d'insertion (2) est fixée sur des zones souhaitées contre la pièce plate ou la pièce de cadre (1) au moyen d'une mousse d'étanchéité (13), qui traverse ou entoure au moins partiellement des ouvertures de la pièce d'insertion (2),
la mousse d'étanchéité (13) est déposée sur la pièce d'insertion (2), et
la pièce d'insertion (2) est enrobée dans la mousse d'étanchéité solidifiée (13) sur les zones de fixation.

2. Système de fixation selon la revendication 1,
**caractérisé en ce que**
la pièce d'insertion (2) est reliée sur sa périphérie à la pièce plate ou à la pièce de cadre (1) au moins partiellement par la mousse d'étanchéité (13).

3. Système de fixation selon la revendication 1 ou 2,
**caractérisé en ce que**
la mousse d'étanchéité (13) est une mousse d'étanchéité à plusieurs composants, notamment à deux composants.

4. Système de fixation selon l'une quelconque des revendications 1 à 3,
**caractérisé en ce que**
la pièce de cadre (1) présente au moins un gradin (31) destiné à recevoir la pièce d'insertion (2), et la partie extérieure du cadre (1) et la pièce d'insertion (2) forment une surface essentiellement plane.

5. Système de fixation selon l'une quelconque des revendications 1 à 4,
**caractérisé en ce que**
la pièce de cadre (1) est une partie d'une porte ou une partie d'une zone latérale d'une armoire informatique ou d'un boîtier, en particulier de la technique de l'informatique, des réseaux ou des serveurs, ou de la technique médicale.

6. Système de fixation selon l'une quelconque des revendications 1 à 5,
**caractérisé en ce que**
la pièce d'insertion est une tôle perforée (2) avec une grande proportion de trous.

7. Système de fixation selon l'une quelconque des revendications 1 à 6,
**caractérisé en ce que**
la mousse d'étanchéité (13) présente des propriétés de compatibilité électromagnétique, et la pièce plate ou la pièce de cadre (1) et la pièce d'insertion sont reliées de façon conductrice par la mousse d'étanchéité (13).

8. Système de fixation selon l'une quelconque des revendications 1 à 7,
**caractérisé en ce que**
des moyens permettant de canaliser un courant d'air sont fixés dans les zones sur lesquelles la pièce d'insertion (2) est enrobée par la mousse d'étanchéité (13).

9. Système de fixation selon la revendication 8,
**caractérisé en ce que**
les moyens permettant de canaliser le courant d'air sont fixés de façon étanche à l'air et/ou hermétique - CEM (Comptabilité Electro-Magnétique).
